(19) Europäisches Patentamt / European Patent Office / Office européen des brevets

(11) **EP 4 596 646 A1**

(12) **EUROPEAN PATENT APPLICATION**
published in accordance with Art. 153(4) EPC

(43) Date of publication:
06.08.2025 Bulletin 2025/32

(21) Application number: 23871788.8

(22) Date of filing: 06.09.2023

(51) International Patent Classification (IPC):
*C09D 201/00* (2006.01)    *C09D 7/20* (2018.01)
*C09D 7/65* (2018.01)    *C09D 133/00* (2006.01)
*C09D 133/18* (2006.01)    *H05K 3/28* (2006.01)

(52) Cooperative Patent Classification (CPC):
C09D 7/20; C09D 7/65; C09D 133/00;
C09D 133/18; C09D 201/00; H05K 3/28

(86) International application number:
PCT/JP2023/032555

(87) International publication number:
WO 2024/070548 (04.04.2024 Gazette 2024/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 28.09.2022 JP 2022155289
30.01.2023 JP 2023012011

(71) Applicant: SEKISUI CHEMICAL CO., LTD.
Osaka-shi
Osaka
530-8565 (JP)

(72) Inventors:
• KAMIYAMA, Akira
Ritto-shi, Shiga 520-3027 (JP)
• ISHII, Youji
Ritto-shi, Shiga 520-3027 (JP)

(74) Representative: Ter Meer Steinmeister & Partner
Patentanwälte mbB
Nymphenburger Straße 4
80335 München (DE)

(54) **COATING AGENT AND ELECTRONIC COMPONENT MODULE MANUFACTURING METHOD**

(57) Provided is a coating agent capable of forming a coating film having high heat insulating properties. The coating agent according to the present invention is a coating agent used for forming a coating film in an electronic component module in which an electronic component is mounted on a circuit board via a conductive adhesive portion, the conductive adhesive portion being coated with a coating film, the coating agent includes a thermoplastic resin, a solvent that dissolves the thermoplastic resin, and hollow particles, in which a content of the thermoplastic resin is 1.0 wt% or more and 22.0 wt% or less based on 100 wt% of a total content of the thermoplastic resin and the solvent, and a content of the hollow particles is 15.0 parts by weight or more and 50.0 parts by weight or less based on 100 parts by weight of the total content of the thermoplastic resin and the solvent.

[FIG. 1]

## Description

### TECHNICAL FIELD

The present invention relates to a coating agent used for an electronic component module. The present invention also relates to an electronic component module manufacturing method using the coating agent.

### BACKGROUND ART

Various electronic component modules have been used in automobiles, personal computers, mobile phones, and the like. As an example of the electronic component module, a vehicle control unit (ECU: Electronic Control Unit) mounted on an automobile is known. The vehicle control device generally includes a mounted body in which an electronic component such as a semiconductor component is mounted on a circuit board, and a casing that houses the mounted body. For example, the electronic component is fixed to the circuit board in a state where a terminal of the electronic component is soldered to a wiring circuit pattern of the circuit board. As disclosed in Patent Document 1, the housing generally includes a base for fixing a circuit board and a cover assembled to the base so as to cover the circuit board.
In addition, Patent Document 2 discloses an electronic component module obtained by installing a mounted body in which an electronic component is mounted on the circuit board in a mold for injection molding and sealing the electronic component on the circuit board with a thermoplastic resin.
In recent years, an electronic component module such as a vehicle control device as described above has been required to be downsized due to space restrictions. Accordingly, downsizing of the electronic components is required.
In recent years, lead-free solder has been widely adopted in order to cope with environmental problems, but it is known that whisker grows over time in the lead-free solder. In the automobile field and the like, electronic circuits also tend to be downsized along with downsizing of the electronic components. In the circuit board using the lead-free solder, there is a problem that adjacent electronic components or solders are short-circuited by the grown whisker. In view of such a problem, Patent Document 3 proposes coating a solder portion with hollow particles.

### Related Art Document

### Patent Documents

Patent Document 1: WO2017/038343A1
Patent Document 2: JP 2012-151296 A
Patent Document 3: JP 2013-131559 A

### SUMMARY OF THE INVENTION

### PROBLEMS TO BE SOLVED BY THE INVENTION

As disclosed in Patent Document 3, the heat insulating properties of the electronic component module may not be sufficiently enhanced by simply using hollow particles.
An object of the present invention is to provide a coating agent capable of forming a coating film having high heat insulating properties. Another object of the present invention is to provide a method for manufacturing an electronic component module having a coating film having high heat insulating properties.

### MEANS FOR SOLVING THE PROBLEMS

The present inventors have considered covering a conductive adhesive portion with a coating film in an electronic component module in which an electronic component is mounted on a circuit board via the conductive adhesive portion. As a result of studying a coating agent used for forming the coating film, the present inventors have found a configuration of a coating agent capable of enhancing the heat insulating properties of the resulting coating film.
In the present specification, the following coating agent and method for manufacturing an electronic component module are disclosed.
Item 1. A coating agent used for forming a coating film in an electronic component module in which an electronic component is mounted on a circuit board via a conductive adhesive portion, the conductive adhesive portion being coated with a coating film, the coating agent including: a thermoplastic resin; a solvent that dissolves the thermoplastic resin; and hollow particles, in which a content of the thermoplastic resin is 1.0 wt% or more and 22.0 wt% or less based on 100 wt% of a total content of the thermoplastic resin and the solvent, and a content of the hollow particles is 15.0 parts by weight or more and 50.0 parts by weight or less based on 100 parts by weight of the total content of the thermoplastic resin and the solvent.

Item 2. The coating agent according to item 1, in which the solvent has a boiling point of 130°C or lower.

Item 3. The coating agent according to item 1 or 2, in which a viscosity at 25°C of a composition containing the thermoplastic resin and the solvent contained in the coating agent in a weight ratio in the coating agent is 1 mPa·s or more and 350 mPa·s or less.

Item 4. The coating agent according to any one of items 1 to 3, in which a hollow rate of the hollow particles is 40 vol% or more and 99 vol% or less.

Item 5. The coating agent according to any one of items 1 to 4, in which a specific gravity of the hollow particles is 5.0 or less.

Item 6. The coating agent according to any one of items 1 to 5, in which a material of the hollow particles contains poly (meth)acrylonitrile or a (meth)acrylic resin.

Item 7. The coating agent according to any one of items 1 to 6, which is a coating agent used to form the coating film in an electronic component module in which the electronic component is mounted on the circuit board via the conductive adhesive portion, in which the conductive adhesive portion is covered with the coating film, and the electronic component on the circuit board is sealed with a thermoplastic resin.

Item 8. An electronic component module manufacturing method, the method including a step of covering a conductive adhesive portion with the coating agent according to any one of items 1 to 6 and forming a coating film that covers the conductive adhesive portion, in a mounted body in which an electronic component is mounted on a circuit board via the conductive adhesive portion.

Item 9. The electronic component module manufacturing method according to item 8, further including a step of mounting the electronic component on the circuit board via the conductive adhesive portion.

Item 10. The electronic component module manufacturing method according to item 8 or 9, further including a step of sealing the electronic component using a thermoplastic resin on the circuit board.

Item 11. The electronic component module manufacturing method according to item 10, in which the electronic component on the circuit board is sealed using the thermoplastic resin, through injection molding in a mold.

**EFFECT OF THE INVENTION**

The coating agent of the present invention is a coating agent used to form the coating film in an electronic component module in which the electronic component is mounted on the circuit board via the conductive adhesive portion, and the conductive adhesive portion is covered with the coating film. The coating agent according to the present invention includes a thermoplastic resin, a solvent that dissolves the thermoplastic resin, and hollow particles. In the coating agent according to the present invention, the content of the thermoplastic resin is 1.0 wt% or more and 22.0 wt% or less based on 100 wt% of the total content of the thermoplastic resin and the solvent, and the content of the hollow particles is 15.0 parts by weight or more and 50.0 parts by weight or less based on 100 parts by weight of the total content of the thermoplastic resin and the solvent. Since the coating agent according to the present invention is provided with the above-described configuration, it is possible to form a coating film having high heat insulating properties.

**BRIEF DESCRIPTION OF DRAWING**

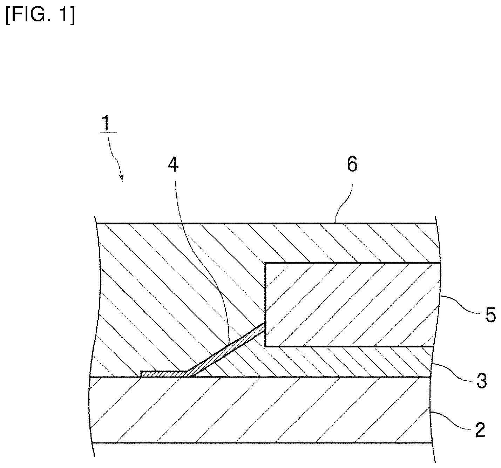

[Fig. 1] Fig. 1 is a cross-sectional view schematically illustrating an electronic component module using a coating agent according to an embodiment of the present invention.

**MODE FOR CARRYING OUT THE INVENTION**

Hereinafter, the present invention will be described in detail.

(Coating agent)

The coating agent of the present invention is a coating agent used to form the coating film in an electronic component module in which the electronic component is mounted on the circuit board via the conductive adhesive portion, and the conductive adhesive portion is covered with the coating film (the coating agent is used to form the coating film in an electronic component module in which the electronic component is mounted on the circuit board via the conductive adhesive portion, and the conductive adhesive portion is covered with the coating film). The coating agent according to the present invention includes a thermoplastic resin, a solvent that dissolves the thermoplastic resin, and hollow particles. In the coating agent according to the present invention, the content of the thermoplastic resin is 1.0 wt% or more and 22.0 wt% or less based on 100 wt% of the total content of the thermoplastic resin and the solvent, and the content of the hollow particles is 15.0 parts by weight or more and 50.0 parts by weight or less based on 100 parts by weight of the total content of the thermoplastic resin and the solvent.

Since the coating agent according to the present invention is provided with the above-described configuration, it is possible to form a coating film having high heat insulating properties. In the coating agent according to the present invention, the heat insulating properties can be made uniformized in the entire coating film. The coating agent according to the present invention can suppress remelting of the conductive adhesive portion and thermal deterioration of the circuit board (stress damage or the like due to thermal expansion of the resin) at the time of manufacturing the electronic component module. In particular, when the step of sealing the electronic component on the circuit board with the thermoplastic resin is performed by injection molding in a mold, remelting of the conductive adhesive portion due to heat during the injection molding and thermal deterioration of the circuit board can be suppressed.

In order to enhance the heat insulating properties, it is conceivable to increase the content of the hollow particles. The present inventors have found that simply increasing the content of the hollow particles in the coating agent increases the viscosity of the coating agent and reduces the dispersibility of the hollow particles in the coating agent. As a result of intensive studies, the present inventors have found that the dispersibility of the hollow particles in the coating agent can be considerably enhanced by setting the content of the thermoplastic resin based on 100 wt% of the total content of the thermoplastic resin and the solvent and the content of the hollow particles based on 100 parts by weight of the total content of the thermoplastic resin and the solvent within the above ranges. By using the coating agent according to the present invention, the heat insulating properties of the coating film can be further enhanced, and the heat insulating properties can be further uniformized in the entire coating film. Controlling each of the content of the thermoplastic resin and the content of the hollow particles within the above ranges greatly contributes to considerably enhancing the heat insulating properties of the coating film and uniformizing the heat insulating properties considerably uniform in the entire coating film.

Hereinafter, components used in the coating agent according to the present invention will be described. In the following description, "(meth)acryl" means one or both of "acryl" and "methacryl". "(Meth)acryloyl" means one or both of "acryloyl" and "methacryloyl".

[Thermoplastic resin]

The coating agent contains a thermoplastic resin (thermoplastic resin for coating). The thermoplastic resin can be used as a known thermoplastic resin in the related art. In the coating agent, the thermoplastic resin is contained in a state of being dissolved in the solvent. In the coating agent, the thermoplastic resin is not contained in a state of particle.

Examples of the thermoplastic resin include synthetic resins and aqueous emulsion resins. Only one kind of the thermoplastic resin may be used, or two or more kinds thereof may be used in combination.

Examples of the synthetic resin (thermoplastic resin) include a polyolefin resin, a phenol resin, an alkyd resin, an aminoalkyd resin, a urea resin, a silicon resin, melamine urea, an epoxy resin, a polyurethane resin, a vinyl acetate resin, a (meth)acrylic resin, a rubber resin, a vinyl chloride resin, and a fluororesin.

From the viewpoint of further enhancing the adhesiveness of the coating film, the thermoplastic resin preferably contains a polyolefin-based resin, and more preferably contains a polyolefin-based elastomer.

Examples of the polyolefin-based elastomer include a copolymer of propylene and an $\alpha$-olefin; $\alpha$-olefin polymer; ethylene-propylene-based rubber such as ethylene-propylene rubber (EPM) and ethylene-propylene-diene rubber (EPDM); and chlorosulfonated polyethylene (CSM).

Examples of the aqueous emulsion resin (thermoplastic resin) include a silicon (meth)acrylic emulsion resin, a urethane emulsion resin, and a (meth)acrylic emulsion resin.

The content of the thermoplastic resin in 100 wt% of the coating agent is preferably 0.7 wt% or more, more preferably 5.0 wt% or more, and still more preferably 10.0 wt% or more, and preferably less than 19.5 wt%, more preferably 19.0 wt% or less, and still more preferably 18.0 wt% or less, particularly preferably 17.0 wt% or less. When the content of the thermoplastic resin is the above lower limit or more and the above upper limit or less (or less than the above upper limit), the heat insulating properties of the coating film can be further enhanced, and the heat insulating properties can be further uniformized in the entire coating film.

The content of the thermoplastic resin is 1.0 wt% or more and 22.0 wt% or less based on 100 wt% of the total content of the thermoplastic resin and the solvent. When the content of the thermoplastic resin is 1.0 wt% or more and 22.0 wt% or less, the heat insulating properties of the coating film can be increased and the heat insulating properties can be uniformized in the entire coating film. The content of the thermoplastic resin is preferably 2.0 wt% or more, more preferably 6.0 wt% or more, and still more preferably 11.0 wt% or more based on 100 wt% of the total content of the thermoplastic resin and the solvent. The content of the thermoplastic resin is preferably 20.0 wt% or less, more preferably less than 20.0 wt, still more preferably 19.0 wt% or less, and particularly preferably 18.0 wt% or less based on 100 wt% of the total content of the thermoplastic resin and the solvent. When the content of the thermoplastic resin is the above lower limit or more and the above upper limit or less (or less than the above upper limit), the heat insulating properties of the coating film can be further enhanced, and the heat insulating properties can be further uniformized in the entire coating film.

[Solvent]

The coating agent contains a solvent. The solvent is a solvent that dissolves the thermoplastic resin. The solvent is a solvent that dissolves the thermoplastic resin. The solvent is preferably capable of dissolving the thermoplastic resin at 25°C. The solvent also functions as a dispersion medium for the hollow particles. The solvent can be appropriately selected and used in consideration of solubility of the thermoplastic resin, volatilization rate, dispersibility of the hollow particles, compatibility with other fillers, compatibility with a dispersant, and the like.

Examples of the solvent include water and an organic solvent. The above solvents may be used alone or in combination of two or more kinds.

Examples of the organic solvent include a ketone-based solvent, an alcohol-based solvent, and an aromatic solvent. Specific examples of the organic solvent include acetone, methyl ethyl ketone, alkylcyclohexane, cyclohexene, ethylene glycol, propylene glycol, methyl alcohol, ethyl alcohol, isopropyl alcohol, butanol, benzene, toluene, xylene, ethyl acetate, and butyl acetate.

From the viewpoint of further enhancing the heat insulating properties of the coating film, the solvent preferably contains the alkylcyclohexane. From the viewpoint of further enhancing the heat insulating properties of the coating film, the alkyl group in the alkylcyclohexane preferably has 1 to 5 carbon atoms.

From the viewpoint of enhancing the solubility of the polyolefin-based resin and further enhancing the heat insulating properties of the coating film, the solvent preferably contains an aliphatic hydrocarbon having 1 to 12 carbon atoms, and more preferably contains methylcyclohexane. In particular, when the thermoplastic resin contains the polyolefin-based resin, the use of these preferred solvents is effective.

From the viewpoint of further enhancing the heat insulating properties of the coating film, the solvent preferably contains toluene or an alkylcyclohexane, and more preferably toluene or methylcyclohexane.

From the viewpoint of further enhancing the heat insulating properties of the coating film, a boiling point of the solvent is preferably 150°C or lower, more preferably 140°C or lower, and still more preferably 130°C or lower. When the boiling point of the solvent is equal to or lower than the upper limit, the coating agent can be quickly dried to form a coating film while suppressing adverse effects on electronic components (capacitors and the like) mounted on the circuit board. The boiling point of the solvent may be 50°C or higher, 60°C or higher, 70°C or higher, 80°C or higher, 100°C or higher, or higher than 100°C. When the boiling point of the solvent is the above lower limit or more (or exceeds the above lower limit), unintended volatilization of the solvent can be suppressed, and the handleability of the coating agent can be enhanced.

[Hollow particles]

The coating agent contains hollow particles. The hollow particles impart the heat insulating properties to the coating film. The hollow particles may be single-pore hollow particles or porous hollow particles. The single-pore hollow particle is a particle having one pore inside the particle. The porous hollow particles are particles having a plurality of pores inside the particles. The plurality of pores in the porous hollow particles may exist independently or may be connected. The solvent is preferably incapable of dissolving the hollow particles. In the coating agent, the hollow particles are contained in the form of particles. The hollow particles are preferably contained in the coating agent without being dissolved in the solvent.

Examples of the hollow particles include organic hollow particles and inorganic hollow particles. The hollow particles may be used alone or in combination of two or more kinds.

Examples of the organic hollow particles include thermoplastic resin particles, thermosetting resin particles, and organic hollow particles (resin hollow particles) having glass as a shell. When the hollow particles are the thermoplastic resin particles, the thermoplastic resin contained in the coating agent is different from the thermoplastic resin particles. When the hollow particles are the thermoplastic resin particles, the solvent is preferably a solvent that does not dissolve the hollow particles as the thermoplastic resin particles. The solvent is preferably a solvent that does not dissolve the hollow particles, which are thermoplastic resin particles, at 25°C.

Examples of the inorganic hollow particles include glass particles and ceramic particles.

From the viewpoint of enhancing the mechanical properties, the hollow particles preferably contain thermoplastic resin particles. Examples of the material (thermoplastic resin) of the thermoplastic resin particles include homopolymers such as monomers having a styrene skeleton (styrene, parachlorostyrene, $\alpha$-methylstyrene, and the like); monomers having (meth)acrylic acid and (meth)acrylic acid esters (methyl (meth)acrylate, ethyl (meth)acrylate, n-propyl (meth)acrylate, n-butyl (meth)acrylate, lauryl (meth)acrylate, (meth)acrylic acid nitrile, 2-ethylhexyl (meth)acrylate, and the like), and the like); vinyl acetate; vinyl ether (vinyl methyl ether, vinyl isobutyl ether, and the like); vinyl ketone (vinyl methyl ketone, vinyl ethyl ketone, vinyl isopropenyl ketone, and the like); olefin (ethylene, propylene, butadiene, and the like), and copolymers obtained by combining two or more of these monomers.

Further, as a material of the hollow particles, a non-vinyl-based resin (epoxy resin, polyester resin, polyurethane resin, polyamide resin, cellulose resin, polyether resin, modified rosin, and the like); a mixture of non-vinyl-based resin and vinyl-based resin; a polymer (graft polymer or the like) obtained by polymerizing a vinyl-based monomer.

From the viewpoint of further enhancing the heat insulating properties of the coating film, the material of the hollow particles preferably contains poly (meth)acrylonitrile or a (meth)acrylic resin.

The hollow particles may be expandable hollow particles or non-expandable hollow particles. The expandable hollow particles are particles in which the volume of the particles (or internal pores) is increased by external stimulation such as heat.

As the hollow particles, commercially available products may be used.

Examples of commercially available products of the hollow particles include Advancell EM and Advancell HB (as described above, manufactured by SEKISUI CHEMICAL CO., LTD.); Expancel WU, Expancel DU, Expancel WE, and Expancel DE (as described above, manufactured by Japan Filite Co., Ltd.); Matsumoto microsphere F, Matsumoto microsphere F-E (as described above, manufactured by Matsumoto Yushi-Seiyaku Co., Ltd.); resin-made hollow particles such as Techpolymer MBP (manufactured by Sekisui Kasei Co., Ltd.). Examples of commercially available products of the hollow particles include inorganic hollow particles such as SiliNax (manufactured by Nittetsu Mining Co., Ltd.); E-SPHERES (manufactured by TAIYO CEMENT INDUSTRIAL); HardLite (manufactured by SHOWA KAGAKU KOGYO CO., LTD.); Senolite, Marlite, Glass Balloon (As described above, manufactured by TOMOE Engineering Co., Ltd.); and glass bubbles (manufactured by 3M).

The hollow rate of the hollow particles is preferably 40 vol% or more, more preferably 45 vol% or more, and preferably 99 vol% or less, more preferably 95 vol% or less, still more preferably 80 vol% or less, particularly preferably 70 vol% or less, and most preferably 60 vol% or less. When the hollow rate is the above lower limit or more and the above upper limit or less, the heat insulating properties of the coating film can be further enhanced, and the heat insulating properties can be further uniformized in the entire coating film. In particular, the shape of the hollow particles can be well maintained after volatilization of the solvent.

The hollow rate of the hollow particles can be measured by the following method.

When the theoretical density of a material constituting the hollow particles is defined as (A) with respect to the measured value (B) of the density of the hollow particles, the hollow rate (C) can be calculated by the following formula.

$$C \ (\%) \ = \ (A \ - \ B)/A \ \times \ 100$$

In the coating film, the hollow particles are preferably uniformly dispersed in the thermoplastic resin. The specific gravity of the hollow particles is preferably 5.0 or less, more preferably 3.0 or less, still more preferably 2.0 or less, and particularly preferably 1.5 or less. When the specific gravity is equal to or less than the upper limit, the hollow particles are more uniformly dispersed in the thermoplastic resin in the coating film, and the heat insulating properties can be more uniformly provided in the entire coating film. The lower limit of the specific gravity of the hollow particles is not particularly limited. The specific gravity of the hollow particles may be 0.01 or more, 0.1 or more, and 1.0 or more.

The specific gravity of the hollow particles means the density (measured value (B)) of the hollow particles with respect to the density (1.0 g/cm³) of water.

An average particle size of the hollow particles is preferably 1 μm or more, more preferably 5 μm or more, and still more preferably 10 μm or more, and preferably 500 μm or less, more preferably 100 μm or less, and still more preferably 70 μm or less. When the average particle size is the above lower limit or more and the above upper limit or less, the heat insulating properties of the coating film can be further enhanced, and the heat insulating properties can be further uniformized in the entire coating film. When the average particle size is the above lower limit or more and the above upper limit or less, occurrence of slip can be suppressed.

The average particle size of the hollow particles means an average value (D50) of particle sizes of the hollow particles in a powder state measured by a laser diffraction scattering particle size distribution measuring method, and means a number average particle size.

The content of the hollow particles is 15.0 parts by weight or more and 50.0 parts by weight or less based on 100 parts by weight of the total content of the thermoplastic resin and the solvent. When the content of the hollow particles is 15.0 parts by weight or more and 50.0 parts by weight or less based on 100 parts by weight of the total content of the thermoplastic resin and the solvent, the heat insulating properties of the coating film can be increased and the heat insulating properties can be uniformized in the entire coating film. The content of the hollow particles is preferably 17.5 parts by weight or more, more preferably 20.0 parts by weight or more, and preferably 45.0 parts by weight or less, more preferably 40.0 parts by weight or less, still more preferably 35.0 parts by weight or less, and particularly preferably 30.0 parts by weight or less based on 100 parts by weight of the total content of the thermoplastic resin and the solvent. When the content of the hollow particles is the above lower limit or more and the above upper limit or less, the heat insulating properties of the coating film can be further enhanced, and the heat insulating properties can be further uniformized in the entire coating film.

[Other details of coating agent]

A viscosity at 25°C of a composition containing the thermoplastic resin and the solvent contained in the coating agent in a weight ratio in the coating agent is preferably 1 mPa·s or more, and preferably 350 mPa·s or less, more preferably 250 mPa·s or less, and still more preferably 150 mPa·s or less. When the viscosity of the composition is the above lower limit or more, it is easy to moderately increase the thickness of the coating film. When the viscosity of the composition is the above lower limit or more and the above upper limit or less, the heat insulating properties can be further enhanced, the viscosity change of the coating agent containing the hollow particles can be suppressed, and the coatability of the coating agent can be enhanced. In particular, when the viscosity of the composition at 25°C is 250 mPa·s or less, the heat insulating properties can be further enhanced, and when the viscosity of the composition at 25°C is 150 mPa·s or less, the heat insulating properties can be considerably enhanced.

The composition for measuring the viscosity contains only the thermoplastic resin and the solvent contained in the coating agent, and contains the thermoplastic resin and the solvent in a weight ratio in the coating agent. The composition for measuring the viscosity does not contain the hollow particles. The composition for measuring the viscosity is, for example, a solution in which the thermoplastic resin is dissolved in the solvent. When the coating agent contains 15 wt% of the thermoplastic resin, 60 wt% of the solvent, and 25 wt% of the hollow particles in 100 wt% of the coating agent, the composition for measuring the viscosity contains 20 wt% of the thermoplastic resin and 80 wt% of the solvent in 100 wt% of the composition.

As described above, the coating agent of the present invention is a coating agent used to form the coating film in an electronic component module in which the electronic component is mounted on the circuit board via the conductive adhesive portion, and the conductive adhesive portion is covered with the coating film. As described above, the coating agent according to the present invention can form a coating film having high heat insulating properties.

The coating agent according to the present invention is a preferably a coating agent used to form the coating film in an electronic component module in which the electronic component is mounted on the circuit board via the conductive adhesive portion, the conductive adhesive portion is covered with the coating film, and the electronic component on the circuit board is sealed with a thermoplastic resin (using a coating agent used to form the coating film in an electronic component module in which the electronic component is mounted on the circuit board via the conductive adhesive portion, the conductive adhesive portion is covered with the coating film, and the electronic component on the circuit board is sealed with a thermoplastic resin). By using the coating agent according to the present invention, even when the electronic component is sealed with the thermoplastic resin, remelting of the conductive adhesive portion due to heat at the time of sealing and thermal deterioration of the circuit board can be suppressed.

(Electronic component module and manufacturing method thereof)

Fig. 1 is a cross-sectional view schematically illustrating an electronic component module using a coating agent according to an embodiment of the present invention.

An electronic component module 1 illustrated in Fig. 1 includes a circuit board 2, a conductive adhesive portion 3, a coating film 4, an electronic component 5, and a thermoplastic resin portion 6.

In the electronic component module 1, the electronic component 5 is mounted on the circuit board 2 via the conductive adhesive portion 3. The circuit board 2 and the electronic component 5 are electrically connected by the conductive adhesive portion 3. The coating film 4 covers the conductive adhesive portion 3. The coating film 4 is also disposed on a part of the surface of the circuit board 2. The electronic component 5 on the circuit board 2 is sealed by the thermoplastic resin portion 6. In addition, the conductive adhesive portion 3 on the circuit board 2 is sealed with the thermoplastic resin portion 6 via the coating film 4. The coating film 4 on the circuit board 2 is sealed by the thermoplastic resin portion 6.

The electronic component module includes a mounted body in which the electronic component is mounted on a circuit board via a conductive adhesive portion, the conductive adhesive portion, and a coating film covering the conductive adhesive portion. The electronic component module preferably includes a thermoplastic resin portion (sealing portion) that seals the electronic component on the circuit board. The coating film is formed of the coating agent described above. The conductive adhesive portion is formed of a conductive adhesive member. The thermoplastic resin portion is formed of a thermoplastic resin (sealing thermoplastic resin).

In the electronic component module, the coating film may cover only a part of the surface of the conductive adhesive portion, or may cover the entire surface of the conductive adhesive portion. In the electronic component module, the coating film is preferably disposed so as to cover the conductive adhesive portion. In the electronic component module, the coating film may cover the entire of the surface of the circuit board, or may cover the entire surface of the circuit board. The conductive adhesive portion on the circuit board is preferably sealed with the thermoplastic resin portion via the coating film. The coating film on the circuit board is preferably sealed with the thermoplastic resin portion.

Examples of the electronic component include a semiconductor element, a resistive chip, a capacitor, and a connection terminal with the outside.

Examples of the conductive adhesive member include a resin material containing a conductive filler, and solder. The conductive adhesive member is preferably solder. Therefore, the conductive adhesive portion formed by the conductive adhesive member is preferably a solder portion. The solder may contain tin (Sn). Examples of the solder include an Sn-Pb-based alloy, an Sn-Ag-Cu-based alloy, an Sn-Zn-Bi-based alloy, and an Sn-Zn-Al-based alloy. From the viewpoint of environmental regulations, the solder is preferably a lead containing no solder (lead-free solder), and more preferably an Sn-Ag-Cu-based alloy, an Sn-Zn-Bi-based alloy, or an Sn-Zn-Al-based alloy.

Examples of the resin in the resin material containing a conductive filler include thermosetting resins such as an epoxy-based resin and a phenol-based resin; thermoplastic resins (thermoplastic resins for conductive adhesive portions) such as a polyester-based resin, a polyolefin-based resin, a polyurethane-based resin, and a polycarbonate-based resin. Examples of the conductive filler in the resin material containing a conductive filler include gold, silver, copper, nickel, and aluminum.

From the viewpoint of enhancing workability at the time of electrically connecting the circuit board and the electronic element, the melting point of the conductive adhesive member is preferably 250°C or less, more preferably 220°C or less, still more preferably 200°C or less, and particularly preferably 190°C or less. When a thermosetting resin or the like is used as a resin in the resin material containing a conductive filler, and the melting point of the thermosetting resin is not able to be measured, the heat-resistant temperature of the thermosetting resin is defined as a melting point of the conductive adhesive member.

The thermoplastic resin that is a material of the thermoplastic resin portion is preferably a thermoplastic resin that can be injection-molded. Examples of the thermoplastic resin include a polyacetal resin, a polyamide resin, a polycarbonate resin, a polybutylene terephthalate resin, a polyethylene terephthalate resin, a polyphenylene sulfide resin, an acrylic resin, and an ABS resin. From the viewpoint of improving moldability and mechanical properties, the thermoplastic resin is preferably a polybutylene terephthalate resin.

In the electronic component module of the related art, when polybutylene terephthalate or the like is used as the material of the thermoplastic resin portion, the temperature during injection molding is generally about 230°C to 270°C, and therefore the conductive adhesive portion may be remelted by heat during injection molding. In the present invention, by forming the coating film covering the conductive adhesive portion, it is possible to reduce the propagation of heat to the conductive adhesive portion and the electronic component, and to suppress remelting of the conductive adhesive member and damage of the electronic component due to thermal expansion of the resin.

The electronic component module is preferably an electronic component module constituting an electronic control unit (ECU). An electronic control unit can be manufactured by mounting an electronic element such as a semiconductor element, a resistive chip, a capacitor, and a connection terminal with the outside on an electronic substrate such as a wiring substrate, and modularizing an electronic component in which a circuit board and each electronic component are electrically connected by a conductive adhesive portion such as solder. The electronic control unit is preferably an electronic control unit for an aircraft or an automobile, and more preferably an electronic control unit related to a sensor.

A mounted body in which the electronic component is mounted on the circuit board via the conductive adhesive portion is generally housed and integrated in a casing to form an electronic component module in order to protect the electronic component. In recent years, downsizing of the electronic component module has been required, and instead of housing an electronic component in a casing, making an electronic component module in which the electronic component itself is sealed and integrated with a thermoplastic resin has been performed. The electronic component module is manufactured by disposing an electronic component in a mold and performing injection molding (in-mold molding). However, when the coating agent in the related art is used, heat of the molten thermoplastic resin is transferred to the electronic component during injection molding, and the conductive adhesive portion such as solder may be remelted, and the electronic component may be damaged by partial remelting of the solder. On the other hand, in the present invention, since a coating film having uniform heat insulating properties can be formed by the coating agent, heat is less likely to be transferred to the solder or the like, and damage of the electronic component can be suppressed. In the present invention, sealing the electronic component with the thermoplastic resin means integrating or protecting the electronic component, the sensors, the connection terminal with the outside, and the like with the thermoplastic resin, and a portion not covered with the thermoplastic resin may exist in the substrate, the sensors, the cable, and the like.

The manufacturing method of the electronic component module is not particularly limited. The manufacturing method of the electronic component module preferably includes the following steps. (1) Mounting an electronic component on a circuit board via a conductive adhesive portion. (2) Forming a coating film covering the conductive adhesive portion by covering the conductive adhesive portion with the coating agent. (3) Sealing the electronic component on the circuit board with a thermoplastic resin (sealing thermoplastic resin).

A mounted body in which the electronic component is mounted on the circuit board via the conductive adhesive portion may be obtained without performing the step (1). (2') It is preferable to perform a step of covering the conductive adhesive portion with the coating agent and forming a coating film that covers the conductive adhesive portion, in a mounted body in which an electronic component is mounted on a circuit board via the conductive adhesive portion.

In the step (2), drying for removing the solvent contained in the coating agent is preferably performed. Drying may be normal temperature (for example, around 25°C) drying or hot air drying.

The step (3) may or may not be performed. From the viewpoint of protecting the electronic component and enhancing the reliability of the electronic component module, the step (3) is preferably performed. In the step (3), the electronic component on the circuit board is preferably sealed with the thermoplastic resin (sealing thermoplastic resin) by injection molding in a mold. The conductive adhesive portion on the circuit board is preferably sealed with the thermoplastic resin portion via the coating film. The coating film on the circuit board is preferably sealed with the thermoplastic resin portion. By using the coating agent according to the present invention, even when the injection molding in the mold is performed, remelting of the conductive adhesive portion due to heat at the time of injection molding and thermal deterioration of the circuit board can be suppressed. By performing so-called in-mold molding, it is possible to manufacture an electronic component module having a desired shape in which an electronic component is sealed and integrated with a thermoplastic resin.

Hereinafter, the present invention will be specifically described with reference to examples and comparative examples. The present invention is not limited only to the following examples.

(Example 1)

A solution which was a mixture of a thermoplastic resin and a solvent ("RF 630" (rubber resin 20 wt%, methylcyclohexane 80 wt%) manufactured by Fuji Chemical Industry Co., Ltd.) was prepared. To 100 parts by weight of this solution (rubber resin 20 wt%, methylcyclohexane 80 wt%), 40 parts by weight of hollow particles ("Advancel HB2051" manufactured by Sekisui Chemical Co., Ltd., porous hollow particles, material: polyacrylonitrile, specific gravity: 0.4, hollow rate: 50 vol%, average particle size: 20 μm) were added, and the mixture was sufficiently stirred to prepare a coating solution (coating agent). Subsequently, the obtained coating solution was applied onto a polyimide film using a bar coater, and dried to evaporate the solvent, thereby forming a coating film.

(Example 2)

A solution which was a mixture of a thermoplastic resin and a solvent ("V985-15E" (polyurethane resin 15 wt%, methylcyclohexane 85 wt%) manufactured by RYODEN KASEI CO., LTD.) was prepared. To 100 parts by weight of this solution (polyurethane resin 15 wt%, methylcyclohexane 85 wt%), 40 parts by weight of hollow particles ("Advancel HB2051" manufactured by Sekisui Chemical Co., Ltd., porous hollow particles, material: polyacrylonitrile, specific gravity: 0.4, hollow rate: 50 vol%, average particle size: 20 μm) were added, and the mixture was sufficiently stirred to prepare a coating solution. Subsequently, the obtained coating solution was applied onto a polyimide film using a bar coater, and dried to evaporate the solvent, thereby forming a coating film.

(Example 3)

Toluene was further added to a mixture of the thermoplastic resin and the solvent ("MX-208" (acrylic resin 24 wt%, toluene 76 wt%) manufactured by SANYU REC., LTD.) to obtain a solution (acrylic resin 20 wt%, toluene 80 wt%). To 100 parts by weight of the obtained solution (acrylic resin 20 wt%, toluene 80 wt%), 19 parts by weight of hollow particles ("Advancel HB2051" manufactured by Sekisui Chemical Co., Ltd., porous hollow particles, material: polyacrylonitrile, specific gravity: 0.4, hollow rate: 50 vol%, average particle size: 20 μm) were added, and the mixture was sufficiently stirred to prepare a coating solution. Subsequently, the obtained coating solution was applied onto a polyimide film using a bar coater, and dried to evaporate the solvent, thereby forming a coating film.

(Example 4)

Toluene was further added to a mixture of the thermoplastic resin and the solvent ("MX-208" (acrylic resin 24 wt%, toluene 76 wt%) manufactured by SANYU REC., LTD.) to obtain a solution (acrylic resin 16 wt%, toluene 84 wt%). To 100 parts by weight of the obtained solution (acrylic resin 16 wt%, toluene 84 wt%), 19 parts by weight of hollow particles ("Advancel HB2051" manufactured by Sekisui Chemical Co., Ltd., porous hollow particles, material: polyacrylonitrile, specific gravity: 0.4, hollow rate: 50 vol%, average particle size: 20 μm) were added, and the mixture was sufficiently stirred to prepare a coating solution. Subsequently, the obtained coating solution was applied onto a polyimide film using a bar coater, and dried to evaporate the solvent, thereby forming a coating film.

(Example 5)

A solution which was a mixture of a thermoplastic resin and a solvent ("RF 630" (rubber resin 20 wt%, methylcyclohexane 80 wt%) manufactured by Fuji Chemical Industry Co., Ltd.) was prepared. To 100 parts by weight of this solution (rubber resin 20 wt%, methylcyclohexane 80 wt%)), 18 parts by weight of hollow particles ("Expancel 920DE40d 30" manufactured by Nippon Filite Co., Ltd., single-hole hollow particles, material: copolymer of acrylic and polyvinylidene chloride, specific gravity: 0.03, hollow rate: 97 vol%, average particle size: 40 $\mu$m) was added. Thereafter, the mixture was sufficiently stirred to prepare a coating solution. Subsequently, the obtained coating solution was applied onto a polyimide film while being pressed and spread using a release paper, and then dried to evaporate the solvent, thereby forming a coating film.

(Comparative example 1)

A solution which was a mixture of a thermoplastic resin and a solvent ("MX-208" (acrylic resin 24 wt%, toluene 76 wt%) manufactured by SANYU REC., LTD.) was prepared. To 100 parts by weight of this solution (acrylic resin 24 wt%, toluene 76 wt%), 19 parts by weight of hollow particles ("Advancel HB2051" manufactured by Sekisui Chemical Co., Ltd., porous hollow particles, material: polyacrylonitrile, specific gravity: 0.4, hollow rate: 50 vol%, average particle size: 20 $\mu$m) were added, and the mixture was sufficiently stirred to prepare a coating solution. Subsequently, the obtained coating solution was applied onto a polyimide film using a bar coater, and dried to evaporate the solvent, thereby forming a coating film.

(Comparative example 2)

A mixture of a thermoplastic resin and a solvent ("RF 630" (rubber resin 20 wt%, methylcyclohexane 80 wt%) manufactured by Fuji Chemical Industry Co., Ltd.) was prepared as a coating solution. This coating solution was applied onto a polyimide film using a bar coater, and dried to evaporate the solvent, thereby forming a coating film.

(Comparative example 3)

A mixture of a thermoplastic resin and a solvent ("V985-15E" (polyurethane resin 15 wt%, methylcyclohexane 85 wt%) manufactured by RYODEN KASEI CO., LTD.) was prepared as a coating solution. This coating solution was applied onto a polyimide film using a bar coater, and dried to evaporate the solvent, thereby forming a coating film.

(Comparative example 4)

A mixture of a thermoplastic resin and a solvent ("MX-208" (acrylic resin 24 wt%, toluene 76 wt%) manufactured by SANYU REC., LTD.) was prepared as a coating solution. This coating solution was applied onto a polyimide film using a bar coater, and dried to evaporate the solvent, thereby forming a coating film.

[Evaluation]

(1) Viscosity at 25°C of Composition Containing Thermoplastic Resin and Solvent contained in Coating Agent in Weight Ratio in Coating Agent

A composition (composition excepting for hollow particles in the coating agent) containing a thermoplastic resin and a solvent contained in a coating agent in a weight ratio in the coating agent was prepared. This composition is a solution in which the thermoplastic resin is dissolved in the above solvent. The viscosity of this composition at 25°C was measured using an E-type viscometer ("TVE22L" manufactured by Toki Sangyo Co., Ltd.).

(2) Heat insulating properties (anti-remelting property of solder)

The substrate was coated with the obtained coating solution by a dipping method, and dried to evaporate (volatilize) the solvent, thereby forming a coating film, and the thickness of the coating film after curing was measured. As a result, the thickness of the coating film formed by one dipping was 180 $\mu$m. In order for the coating film having a thickness of 180 $\mu$m to have heat insulating properties that do not cause remelting of solder during injection molding, the thermal conductivity of the coating film needs to be 0.1200 W/m·K or less. The thermal conductivity of the coating film was measured by an unsteady method thin wire heating method.

From the thermal conductivity of the coating film, the heat insulating properties (anti-remelting property of solder) was determined according to the following criteria.

[Criteria for heat insulating properties (anti-remelting property of solder)]

∘: The thermal conductivity of the coating film is 0.1200 W/m·K or less.
×: The thermal conductivity of the coating film is more than 0.1200 W/m·K.

The compositions and results are shown in Tables 1 and 2 below.

[Table 1]

| | | | Example 1 | Example 2 | Example 3 | Example 4 | Example 5 |
|---|---|---|---|---|---|---|---|
| Formulation Component | Thermoplastic Resin | Types | Rubber Resin | Polyurethane Resin | Acrylic Resin | Acrylic Resin | Rubber Resin |
| | | Content (parts by weight) | 20 | 15 | 20 | 16 | 20 |
| | Solvent | Type | Methylcyclohexane | Methylcyclohexane | Toluene | Toluene | Methylcyclohexane |
| | | Content (parts by weight) | 80 | 85 | 80 | 84 | 80 |
| | Hollow particles | Content (parts by weight) | 40 | 40 | 19 | 19 | 18 |
| Content (wt%) of thermoplastic resin based on 100 wt% of total content of thermoplastic resin and solvent | | | 20.0 | 15.0 | 20.0 | 16.0 | 20.0 |
| Content (wt%) of thermoplastic resin in 100 wt% of coating agent | | | 14.3 | 10.7 | 16.8 | 13.4 | 16.9 |
| Content (parts by weight) of hollow particles with respect to 100 parts by weight of total content of thermoplastic resin and solvent | | | 40 | 40 | 19 | 19 | 18 |
| Evaluation | Viscosity (mPa·s) | | 120 | 16 | 310 | 250 | 120 |
| | Thermal conductivity (W/m·K) | | 0.0908 | 0.0934 | 0.1166 | 0.1141 | 0.0368 |
| | Heat insulating properties (anti-remelting property of solder) | | ○ | ○ | ○ | ○ | ○ |

[Table 2]

| | | | Comparative Example 1 | Comparative Example 2 | Comparative Example 3 | Comparative Example 4 |
|---|---|---|---|---|---|---|
| Formulation Component | Thermoplastic Resin | Types | Acrylic Resin | Rubber Resin | Polyurethane Resin | Acrylic Resin |
| | | Content (parts by weight) | 24 | 20 | 15 | 24 |
| | Solvent | Type | Toluene | Methylcyclohexane | Methylcyclohexane | Toluene |
| | | Content (parts by weight) | 76 | 80 | 85 | 76 |
| | Hollow particles | Content (parts by weight) | 19 | 0 | 0 | 0 |
| Content (wt%) of thermoplastic resin based on 100 wt% of total content of thermoplastic resin and solvent | | | 24.0 | 20.0 | 15.0 | 24.0 |
| Content (wt%) of thermoplastic resin in 100 wt% of coating agent | | | 20.2 | 20.0 | 15.0 | 24.0 |
| Content (parts by weight) of hollow particles with respect to 100 parts by weight of total content of thermoplastic resin and solvent | | | 19 | 0 | 0 | 0 |
| Evaluation | Viscosity (mPa·s) | | 370 | 120 | 16 | 370 |
| | Thermal conductivity (W/m·K) | | 0.1208 | 0.1691 | 0.1606 | 0.1674 |
| | Heat insulating properties (anti-remelting property of solder) | | × | × | × | × |

**EXPLANATION OF SYMBOLS**

1: ELectronic component module
2: Circuit board
3: Conductive adhesive portion
4: Coating film
5: Electronic component
6: Thermoplastic resin portion

**Claims**

1. A coating agent used for forming a coating film in an electronic component module in which an electronic component is mounted on a circuit board via a conductive adhesive portion, the conductive adhesive portion being coated with a coating film, the coating agent comprising:

a thermoplastic resin;
a solvent that dissolves the thermoplastic resin; and
hollow particles,
a content of the thermoplastic resin being 1.0 wt% or more and 22.0 wt% or less based on 100 wt% of a total

EP 4 596 646 A1

content of the thermoplastic resin and the solvent, and
a content of the hollow particles being 15.0 parts by weight or more and 50.0 parts by weight or less based on 100 parts by weight of the total content of the thermoplastic resin and the solvent.

2. The coating agent according to claim 1, wherein the solvent has a boiling point of 130°C or lower.

3. The coating agent according to claim 1 or 2, wherein a viscosity at 25°C of a composition containing the thermoplastic resin and the solvent contained in the coating agent in a weight ratio in the coating agent is 1 mPa·s or more and 350 mPa·s or less.

4. The coating agent according to any one of claims 1 to 3, wherein a hollow rate of the hollow particles is 40 vol% or more and 99 vol% or less.

5. The coating agent according to any one of claims 1 to 4, wherein a specific gravity of the hollow particles is 5.0 or less.

6. The coating agent according to any one of claims 1 to 5, wherein a material of the hollow particles contains poly (meth) acrylonitrile or a (meth)acrylic resin.

7. The coating agent according to any one of claims 1 to 6, which is a coating agent used to form the coating film in an electronic component module in which the electronic component is mounted on the circuit board via the conductive adhesive portion, wherein the conductive adhesive portion is covered with the coating film, and the electronic component on the circuit board is sealed with a thermoplastic resin.

8. An electronic component module manufacturing method, the method comprising a step of covering a conductive adhesive portion with the coating agent according to any one of claims 1 to 6 and forming a coating film that covers the conductive adhesive portion, in a mounted body in which an electronic component is mounted on a circuit board via the conductive adhesive portion.

9. The electronic component module manufacturing method according to claim 8, further comprising a step of mounting the electronic component on the circuit board via the conductive adhesive portion.

10. The electronic component module manufacturing method according to claim 8 or 9, further comprising a step of sealing the electronic component using a thermoplastic resin on the circuit board.

11. The electronic component module manufacturing method according to claim 10, wherein the electronic component on the circuit board is sealed using the thermoplastic resin, through injection molding in a mold.

[FIG. 1]

## INTERNATIONAL SEARCH REPORT

| International application No. |
| --- |
| **PCT/JP2023/032555** |

| | |
| --- | --- |
| **A. CLASSIFICATION OF SUBJECT MATTER** | |

***C09D 201/00***(2006.01)i; ***C09D 7/20***(2018.01)i; ***C09D 7/65***(2018.01)i; ***C09D 133/00***(2006.01)i; ***C09D 133/18***(2006.01)i; ***H05K 3/28***(2006.01)i
    FI:   C09D201/00; C09D7/65; C09D7/20; C09D133/00; C09D133/18; H05K3/28 Z; H05K3/28 G

According to International Patent Classification (IPC) or to both national classification and IPC

| | |
| --- | --- |
| **B. FIELDS SEARCHED** | |

Minimum documentation searched (classification system followed by classification symbols)

    C09D1/00-10/00; C09D101/00-201/10; C09D7/65; H01L21/447-21/449; H01L21/60-21/607;H05K3/28

Documentation searched other than minimum documentation to the extent that such documents are included in the fields searched

    Published examined utility model applications of Japan 1922-1996
    Published unexamined utility model applications of Japan 1971-2023
    Registered utility model specifications of Japan 1996-2023
    Published registered utility model applications of Japan 1994-2023

Electronic data base consulted during the international search (name of data base and, where practicable, search terms used)

| | |
| --- | --- |
| **C. DOCUMENTS CONSIDERED TO BE RELEVANT** | |

| Category* | Citation of document, with indication, where appropriate, of the relevant passages | Relevant to claim No. |
| --- | --- | --- |
| A | WO 2022/191063 A1 (SEKISUI CHEMICAL CO LTD) 15 September 2022 (2022-09-15) claims 1-19, paragraphs [0001], [0005]-[0006], [0096]-[0121], examples, fig. 1 | 1-11 |
| A | WO 2022/130574 A1 (SEKISUI KASEI CO LTD) 23 June 2022 (2022-06-23) claims 1-3, paragraphs [0024], [0036], [0041], [0048]-[0239], examples | 1-11 |
| A | WO 2020/116539 A1 (SEKISUI CHEMICAL CO LTD) 11 June 2020 (2020-06-11) claims 1-2, 5, 7, paragraphs [0001], [0006]-[0007], [0020]-[0024], [0033]-[0041], [0051]-[0052], examples | 1-11 |
| A | WO 2020/184545 A1 (SEKISUI CHEMICAL CO LTD) 17 September 2020 (2020-09-17) claims 1, 9-13, paragraphs [0001], [0006]-[0007], [0022]-[0036], examples | 1-11 |
| A | JP 2016-68648 A (HITACHI AUTOMOTIVE SYSTEMS LTD) 09 May 2016 (2016-05-09) claims 1-9, paragraphs [0006]-[0008], [0041]-[0045], examples | 1-11 |
| A | US 2014/0345923 A1 (MILLER, Dennis, J.) 27 November 2014 (2014-11-27) claims 1-12, paragraphs [0002], [0017]-[0020], fig. 2, 3 | 1-11 |

| | | | |
| --- | --- | --- | --- |
| ☐ Further documents are listed in the continuation of Box C. | | ☑ See patent family annex. | |

| | | |
| --- | --- | --- |
| \* Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
| --- | --- |
| **27 October 2023** | **07 November 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
### Information on patent family members

| International application No. |
| --- |
| **PCT/JP2023/032555** |

| Patent document cited in search report | Publication date (day/month/year) | Patent family member(s) | Publication date (day/month/year) |
| --- | --- | --- | --- |
| WO 2022/191063 A1 | 15 September 2022 | (Family: none) | |
| WO 2022/130574 A1 | 23 June 2022 | (Family: none) | |
| WO 2020/116539 A1 | 11 June 2020 | US 2022/0046804 A1<br>claims 1-2, 5, 7, paragraphs [0001], [0008]-[0009], [0019]-[0023], [0032]-[0041], [0051]-[0052], examples<br>EP 3893273 A1<br>CN 113169142 A | |
| WO 2020/184545 A1 | 17 September 2020 | US 2022/0124911 A1<br>claims 1, 9-13, paragraphs [0001], [0008]-[0010], [0039]-[0055], examples<br>CN 113491009 A | |
| JP 2016-68648 A | 09 May 2016 | US 2017/0215271 A1<br>claims 1-9, paragraphs [0007]-[0009], [0051]-[0054], examples<br>EP 3202625 A1<br>CN 106687336 A | |
| US 2014/0345923 A1 | 27 November 2014 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017038343 A1
- JP 2012151296 A
- JP 2013131559 A